(19) Europäisches Patentamt / European Patent Office / Office européen des brevets

(11) **EP 3 376 267 B1**

(12) **FASCICULE DE BREVET EUROPEEN**

(45) Date de publication et mention
de la délivrance du brevet:
**18.11.2020 Bulletin 2020/47**

(51) Int Cl.:
*G02B 5/20* (2006.01)    *G02B 5/28* (2006.01)
*H01L 27/146* (2006.01)    *H04N 5/225* (2006.01)

(21) Numéro de dépôt: **18161331.6**

(22) Date de dépôt: **12.03.2018**

(54) **FILTRE INTERFÉRENTIEL**

INTERFERENZFILTER

INTERFERENCE FILTER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **14.03.2017 FR 1752067**

(43) Date de publication de la demande:
**19.09.2018 Bulletin 2018/38**

(73) Titulaire: **Commissariat à l'Energie Atomique et
aux Energies
Alternatives
75015 Paris (FR)**

(72) Inventeur: **FREY, Laurent
38600 FONTAINE (FR)**

(74) Mandataire: **Cabinet Beaumont
4, Place Robert Schuman
B.P. 1529
38025 Grenoble Cedex 1 (FR)**

(56) Documents cités:
**EP-A1- 2 991 115        WO-A1-2010/046369
WO-A1-2010/139794     WO-A1-2012/010812
FR-A1- 2 994 282        FR-A1- 3 020 878
US-B2- 8 933 389**

**Description**

Domaine

La présente demande concerne un filtre interférentiel, notamment pour un capteur d'images, et un procédé de fabrication d'un tel filtre interférentiel.

Exposé de l'art antérieur

Il est connu de réaliser des matrices de filtres interférentiels, en particulier pour les capteurs d'images, également appelés imageurs, dans le domaine du visible, de l'infra-rouge (notamment de 650 nm à 1050 nm) et/ou de l'ultraviolet, qui nécessitent de séparer plusieurs plages de fréquence. Une telle matrice de filtres est également appelée filtre pixellisé, un pixel de filtre, ou filtre élémentaire, correspondant au plus petit élément du filtre ayant les mêmes propriétés de filtrage.

Un exemple d'application d'un filtre pixélisé correspond à un capteur d'images couleur. Le filtre pixélisé peut alors comprendre des premiers pixels de filtre laissant passer la lumière rouge, des deuxièmes pixels de filtre laissant passer la lumière verte et des troisièmes pixels du filtre laissant passer la lumière bleue. Les pixels du filtre peuvent alors avoir sensiblement les mêmes dimensions latérales que les sites de photodétection du capteur.

Un autre exemple d'application d'un filtre pixélisé correspond à un capteur d'images à compensation du décalage spectral sous incidence spatialement variable. En effet, le rayonnement qui atteint le capteur peut avoir une incidence, par rapport à la face exposée du capteur, qui augmente au fur et à mesure que l'on s'éloigne du centre de cette face. Le filtre pixélisé peut alors comprendre différents pixels de filtre recevant le rayonnement à des incidences différentes, les réponses spectrales de chaque pixel de filtre étant sensiblement identiques quelle que soit l'incidence.

Un filtre interférentiel est réalisé par un empilement de plusieurs couches. A titre d'exemple, un filtre interférentiel peut comprendre un empilement de couches semi-réfléchissantes métalliques séparées par des couches diélectriques et/ou une alternance de couches diélectriques ayant des indices de réfraction différents, également appelés indices optiques par la suite. Les épaisseurs des couches du filtre dépendent des propriétés de filtrage souhaitées.

La réalisation d'un filtre pixélisé requiert la réalisation de couches diélectriques ayant des épaisseurs différentes selon le pixel de filtre considéré. Le procédé de fabrication du filtre pixélisé comprend alors généralement le dépôt d'une couche diélectrique sur l'ensemble de la structure et la gravure de la couche diélectrique pour ne conserver la couche diélectrique que sur certains pixels de filtre. La couche diélectrique ou métallique suivante est alors déposée sur une surface présentant des reliefs ou marches, ce qui entraîne un report de ce relief de couche en couche jusqu'au sommet de l'empilement.

De façon générale, les dépôts de couches sont au moins partiellement conformes, c'est-à-dire que la couche se dépose non seulement sur les surfaces horizontales dans le plan des couches, mais également sur les flancs des couches précédemment gravées. Il se forme ainsi un espaceur latéral, ou zone de transition, à chaque dépôt successif dès qu'un relief est présent. La dimension latérale de la zone de transition entre deux pixels de filtre adjacents augmente donc au fur et à mesure des dépôts, entre le relief initial et le haut de l'empilement.

Un inconvénient est que si une partie de la lumière parvient sur les espaceurs, cela entraîne une perte de signal par diffusion et/ou une distorsion des réponses spectrales des pixels de filtre. Ces pertes peuvent devenir importantes lorsque la largeur des espaceurs n'est pas négligeable par rapport à la dimension latérale, ou taille, du pixel de filtre. Ceci peut notamment se produire dans le cas de petits pixels de filtre, dont la dimension latérale est inférieure à 2 $\mu$m, même lorsque les couches du filtre interférentiel ont une épaisseur de quelques centaines de nanomètres. Ceci peut également se produire pour des pixels de filtre plus gros, dont la dimension latérale est supérieure à 2 $\mu$m, avec des couches du filtre interférentiel de quelques micromètres.

Le document US8933389B2 décrit un filtre optique comprenant des plots de dimensions nanométriques réalisés dans un premier matériau diélectrique et noyés dans une couche d'un deuxième matériau diélectrique ayant un indice de réfraction différent, l'espace entre les plots et les dimensions latérales des plots étant ajustés en fonction du filtrage souhaité. Un inconvénient d'un tel filtre est que l'écart entre les plots doit être nettement inférieur à la longueur d'onde du rayonnement filtré. La fabrication des plots requiert alors des procédés de lithographie à haute résolution, par exemple des procédés de lithographie par immersion ou des procédés de lithographie électronique. Toutefois, les procédés de lithographie par immersion ne sont généralement utilisés à une échelle industrielle que pour les premières étapes de fabrication d'un circuit intégré, notamment pour la fabrication de transistors MOS. En outre, les procédés de lithographie électronique ont généralement des vitesses d'écriture trop faibles pour une application à une échelle industrielle

Un autre document d'art antérieur est connu sous la forme FR3020878.

Résumé

Un objet d'un mode de réalisation est de pallier tout ou partie des inconvénients des filtres interférentiels et de leurs procédés de fabrication décrits précédemment.

Un autre objet d'un mode de réalisation est que le filtre interférentiel peut être fabriqué avec des équipements standards de lithographie optique.

Un autre objet d'un mode de réalisation est que les dimensions latérales des espaceurs du filtre interférentiel sont réduites.

Ainsi, un mode de réalisation prévoit un filtre interférentiel tel que défini dans la revendication 1.

D'autres modes de réalisation sont définis dans les revendications dépendantes.

Un mode de réalisation prévoit également un capteur d'images défini dans la revendication 6.

Selon un mode de réalisation, le capteur est un capteur d'images couleur, le premier filtre élémentaire est un filtre passe-bande centré sur une première longueur d'onde et le deuxième filtre élémentaire est un filtre passe-bande centré sur une deuxième longueur d'onde.

Selon un mode de réalisation, le capteur est un capteur d'images couleur, le premier filtre élémentaire est un filtre passe-bande centré sur une troisième longueur d'onde pour un rayonnement à une première incidence par rapport au filtre interférentiel et le deuxième filtre élémentaire est un filtre passe-bande centré sur la troisième longueur d'onde à 1 % près pour le rayonnement à une deuxième incidence par rapport au filtre interférentiel.

Un mode de réalisation prévoit également un procédé de fabrication d'un filtre interférentiel tel que défini dans la revendication 9.

Selon un mode de réalisation, l'étape d) comprend les étapes suivantes :

dépôt d'une troisième couche diélectrique du deuxième matériau diélectrique sur la deuxième couche ; et
gravure de la troisième couche diélectrique jusqu'à atteindre la deuxième couche diélectrique au deuxième emplacement.

Selon un mode de réalisation, la gravure de la troisième couche diélectrique comprend une étape de polissage mécano-chimique.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

les figures 1 et 2 sont des vues en coupe, partielles et schématiques, de modes de réalisation d'un filtre interférentiel ;
les figures 3A à 3G sont des vues en coupe, partielles et schématiques, de structures obtenues à des étapes successives du mode de réalisation d'un procédé de fabrication du filtre interférentiel de la figure 1 ;
les figures 4 à 7 sont des vues en coupe, partielles et schématiques, de modes de réalisation d'un capteur d'images comprenant un filtre interférentiel ;
la figure 8 est une vue en coupe, partielle et schématique, d'un mode de réalisation d'un filtre interférentiel pour un capteur d'images couleur et infra-rouge ;
la figure 9 représente des courbes de transmission de pixels de filtre du filtre de la figure 8 ;
les figures 10 et 11 sont des figures analogues aux figures 8 et 9 d'un exemple de comparaison d'un filtre interférentiel pour un capteur d'images couleur et infra-rouge ;
la figure 12 représente des courbes de transmission de quatre pixels d'un autre mode de réalisation d'un filtre pour un capteur d'images couleur et infra-rouge ;
la figure 13 est une vue en coupe, partielle et schématique, d'un mode de réalisation d'un filtre interférentiel pour un capteur infra-rouge à compensation d'inclinaison ;
la figure 14 représente des courbes de transmission de pixels de filtre du filtre de la figure 13 ; et
les figures 15 et 16 sont des figures analogues aux figures 12 et 13 d'un exemple de comparaison d'un filtre interférentiel pour un capteur infra-rouge à compensation d'inclinaison.

Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de traitement des signaux fournis par les capteurs décrits ci-après sont à la portée de l'homme de l'art et ne sont pas décrits. Dans la suite de la description, sauf indication contraire, les termes "sensiblement", "environ" et "de l'ordre de" signifient "à 10 % près". En outre, dans la suite de la description, on appelle taille ou dimension latérale d'un élément d'un capteur, la dimension maximale de cet élément dans un plan perpendiculaire à la direction d'empilement des couches formant le capteur.

Dans la suite de la description, l'indice de réfraction du matériau signifie l'indice de réfraction du matériau sur la plage de fonctionnement du filtre interférentiel en considérant que l'indice de réfraction du matériau est sensiblement constant sur la plage de longueurs d'ondes de fonctionnement du filtre interférentiel ou l'indice de réfraction moyen du matériau sur la plage de fonctionnement du filtre interférentiel dans le cas où l'indice de réfraction du matériau varie sur la plage de longueurs d'ondes de fonctionnement du filtre interférentiel.

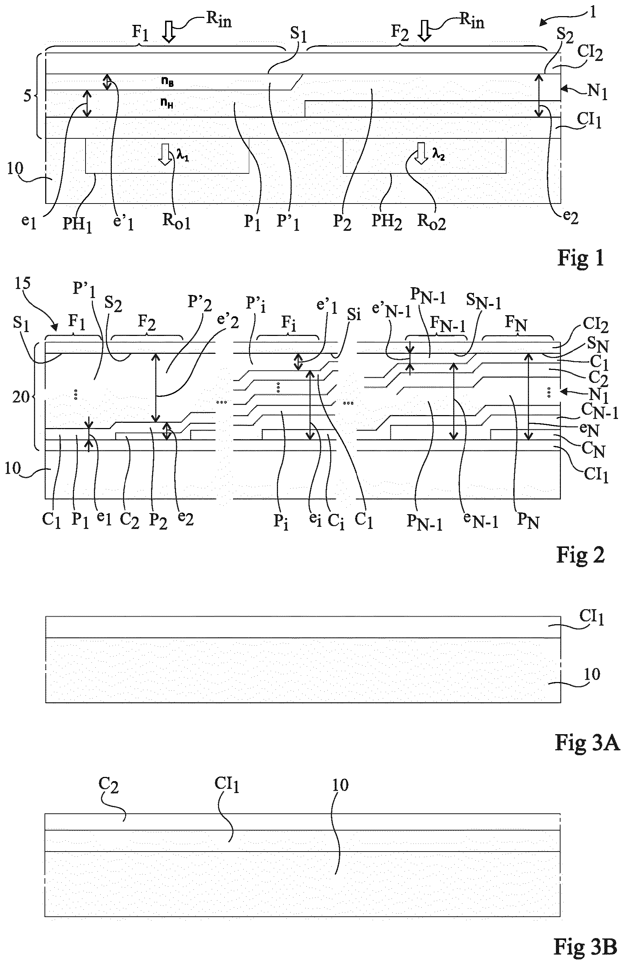

La figure 1 représente un mode de réalisation d'un circuit optoélectronique 1 comprenant un filtre interférentiel 5 reposant sur un support 10. Le support 10 peut correspondre à un capteur d'images comprenant, par exemple, deux photodétecteurs $PH_1$ et $PH_2$. Dans le présent mode de réalisation, le filtre 5 comprend deux pixels de filtre $F_1$ et $F_2$, le pixel de filtre $F_1$ recouvrant le photodétecteur $PH_1$ et le pixel de filtre $F_2$ recouvrant le photodétecteur $PH_2$. En outre, dans le présent mode de réalisation, le filtre 5 comprend un niveau de filtrage $N_1$. Le niveau de filtrage $N_1$ comprend du bas vers le haut en figure 1 :

une première couche d'interface $CI_1$ ;
des portions $P_1$ et $P_2$ d'un premier matériau diélectrique ayant un indice de réfraction haut $n_H$ reposant sur la couche d'interface $CI_1$, de préférence au contact de la couche d'interface $CI_1$, la portion $P_1$ ayant une épaisseur $e_1$ et étant située au niveau du pixel de filtre $F_1$ et la portion $P_2$ ayant une épaisseur $e_2$, supérieure strictement à l'épaisseur $e_1$, et étant située au niveau du pixel de filtre $F_2$, la portion $P_2$ délimitant une surface $S_2$ sensiblement plane, opposée à la couche d'interface $CI_1$ ;
une portion $P'_1$ d'épaisseur $e'_1$ d'un deuxième matériau diélectrique ayant un indice de réfraction bas $n_B$, inférieur strictement à l'indice de réfraction $n_H$, reposant sur la portion $P_1$, de préférence en contact avec la portion $P_1$, et délimitant une surface $S_1$ sensiblement plane, opposée à la couche réfléchissante $CI_1$ sensiblement coplanaire avec la surface $S_2$ ; et
une deuxième couche d'interface $CI_2$ reposant sur les portions $P'_1$ et $P_2$, de préférence au contact des portions $P'_1$ et $P_2$.

Le premier matériau diélectrique est, en outre, de préférence transparent, c'est-à-dire avec un coefficient d'extinction inférieur à $5.10^{-3}$, dans la plage de fonctionnement des pixels de filtre $F_1$ et $F_2$. Le deuxième matériau diélectrique est, en outre, de préférence transparent, c'est-à-dire avec un coefficient d'extinction inférieur à $5.10^{-3}$, dans la plage de fonctionnement des pixels de filtre $F_1$ et $F_2$.

Chaque couche d'interface $CI_1$ et $CI_2$ peut correspondre à une couche unique (en un matériau diélectrique ou métallique), ou à un empilement de deux couches ou de plus de deux couches (en matériaux diélectriques).

L'ensemble comprenant l'empilement de la partie de la couche d'interface $CI_1$ sous la portion $P_1$ du premier matériau diélectrique, de la portion $P_1$ du premier matériau diélectrique, de la portion $P'_1$ du deuxième matériau diélectrique et de la partie de la couche d'interface $CI_2$ sur la portion $P'_1$ du deuxième matériau diélectrique forme le pixel de filtre $F_1$. L'ensemble comprenant l'empilement de la partie de la couche d'interface $CI_1$ sous la portion $P_2$ du premier matériau diélectrique, de la portion $P_2$ du premier matériau diélectrique, et de la partie de la couche d'interface $CI_2$ reposant sur la portion $P_2$ du deuxième matériau diélectrique forme le pixel de filtre $F_2$.

Le filtre 5 reçoit un rayonnement incident $R_{in}$. Le filtre 5 fournit au support 10 un premier rayonnement $R_{O1}$ au photodétecteur $PH_1$ qui correspond à la partie du rayonnement incident $R_{in}$ filtrée par le pixel de filtre $F_1$. Le filtre 5 fournit au support 10 un deuxième rayonnement $R_{O2}$ au photodétecteur $PH_2$ qui correspond à la partie du rayonnement incident $R_{in}$ filtrée par le pixel de filtre $F_2$.

La figure 2 représente un autre mode de réalisation d'un circuit optoélectronique 15 comprenant un filtre interférentiel 20 qui correspond à une généralisation du filtre interférentiel 5 à plus de deux pixels de filtre. Dans le présent mode de réalisation, le niveau de filtrage $N_1$ comprend N pixels de filtre $F_1$ à $F_N$, où N est un nombre entier variant de 2 à 20.

Chaque pixel de filtre $F_i$, i variant de 1 à N-1, comprend un empilement, pris en sandwich entre les couches d'interface $CI_1$ et $CI_2$, d'une portion $P_i$ d'épaisseur $e_i$ du premier matériau diélectrique recouverte d'une portion $P'_i$ d'épaisseur $e'_i$ du deuxième matériau diélectrique, la portion $P'_i$ délimitant une surface $S_i$ en contact avec la couche d'interface $CI_2$. Le pixel de filtre $F_N$ comprend seulement une portion $P_N$ du premier matériau diélectrique prise en sandwich entre les couches d'interface $CI_1$ et $CI_2$, la portion $P_N$ délimitant une surface $S_N$ en contact avec la couche d'interface $CI_2$. Pour i variant de 1 à N-2, l'épaisseur $e_{i+1}$ est supérieure strictement à l'épaisseur $e_i$ et l'épaisseur $e'_{i+1}$ est inférieure strictement à l'épaisseur $e'_i$. Pour i variant de 1 à N-1, la somme des épaisseurs $e_i$ et $e'_i$ est égale à l'épaisseur $e_N$. De ce fait, les surfaces $S_1$ à $S_N$ sont sensiblement coplanaires.

Selon un mode de réalisation, chaque portion $P_i$ est formée par l'empilement de couches $C_1$ à $C_i$ du premier

matériau diélectrique. Selon un mode de réalisation, la couche $C_1$ s'étend sur tous les pixels de filtre $F_1$ à $F_N$ et la couche $C_N$ s'étend seulement sur le pixel de filtre $F_N$. La couche $C_i$ s'étend sur les pixels de filtre $F_i$ à $F_N$ et ne s'étend pas sur les pixels de filtre $F_1$ à $F_{N-i}$. A titre de variante, les couches $C_1$ à $C_i$ peuvent ne pas être toutes dans le même premier matériau diélectrique. Elles sont toutefois toutes en un matériau diélectrique dont l'indice de réfraction est supérieur strictement à l'indice de réfraction $n_B$.

Dans les modes de réalisation décrits précédemment, le filtre interférentiel comprend un seul niveau de filtrage $N_1$. Toutefois, le filtre interférentiel peut comprendre un empilement de deux niveaux de filtrage ou un empilement de plus de deux niveaux de filtrage, chaque niveau de filtrage pouvant avoir la structure décrite précédemment en relation avec la figure 2, une couche d'interface pouvant être commune à deux niveaux de filtre successifs.

Les inventeurs ont mis en évidence qu'il est possible d'obtenir un filtre pixélisé 20 comprenant des pixels de filtre correspondant à des filtres passe-bandes adaptés à globalement filtrer un rayonnement entre deux longueurs d'onde $\lambda_1$ et $\lambda_2$, lorsque l'écart entre l'indice de réfraction $n_H$ à la longueur d'onde $\lambda_2$ et l'indice de réfraction bas $n_B$ à la longueur d'onde $\lambda_1$ est supérieur à un seuil donné. En particulier, lorsque les couches d'interface $CI_1$, $CI_2$ sont des couches semi-réfléchissantes métalliques, les inventeurs ont mis en évidence qu'il est possible d'obtenir un filtre pixélisé 20 comprenant des pixels de filtre correspondant à des filtres passe-bandes adaptés à globalement filtrer un rayonnement entre deux longueurs d'onde $\lambda_1$ et $\lambda_2$, lorsque l'indice de réfraction $n_H$ à la longueur d'onde $\lambda_2$ et l'indice de réfraction bas $n_B$ à la longueur d'onde $\lambda_1$ vérifient la relation suivante :

$$n_H(\lambda_2)/n_B(\lambda_1) \geq \lambda_2/\lambda_1$$

Selon un mode de réalisation, les première et deuxième couches d'interface $CI_1$, $CI_2$ sont des couches semi-réfléchissantes, par exemple des couches métalliques, notamment en argent (Ag), éventuellement dopé pour améliorer la résistance mécanique ou réduire les effets de vieillissement. En particulier, dans le cas d'une utilisation du filtre interférentiel pour un capteur couleur ou un capteur couleur et infrarouge, les couches d'interface $CI_1$, $CI_2$ sont de préférence des couches semi-réfléchissantes métalliques.

Selon un mode de réalisation, chaque couche d'interface $CI_1$, $CI_2$ comprend au moins deux couches diélectriques d'indices de réfraction différents avec un contraste d'indice d'au moins 0,5.

L'indice de réfraction $n_H$ peut être compris entre 1,8 et 3,8. L'indice de réfraction $n_B$ peut être compris entre 1,3 et 2,5.

Le premier matériau diélectrique peut être choisi parmi le groupe comprenant le nitrure de silicium (SiN), le silicium amorphe (aSi), l'oxyde d'hafnium (HfO$_x$), l'oxyde d'aluminium (AlO$_x$), un film à base d'aluminium, d'oxygène et d'azote (AlO$_x$N$_y$), un film à base de silicium, d'oxygène, de carbone et d'azote (SiO$_x$C$_y$N$_z$), le nitrure de silicium (SiN$_x$), l'oxyde de niobium (NbO$_x$), l'oxyde de tantale (TaO$_x$), l'oxyde de titane (TiO$_x$), le silicium amorphe hydrogéné (aSiH) et les mélanges d'au moins deux de ces composés. Chaque couche $C_i$ peut avoir une épaisseur comprise entre 5 nm et 100 nm. L'épaisseur $e_N$ peut être comprise entre 50 nm et 150 nm.

Le deuxième matériau diélectrique peut être choisi parmi le groupe comprenant le dioxyde de silicium (SiO$_2$), le fluorure de magnésium (MgF$_2$), l'oxyde de silicium (SiO$_x$), l'oxynitrure de silicium (SiO$_x$N$_y$), l'oxyde d'hafnium (HfO$_x$), l'oxyde d'aluminium (AlO$_x$), un film à base d'aluminium, d'oxygène et d'azote (AlO$_x$N$_y$), un film à base de silicium, d'oxygène, de carbone et d'azote (SiO$_x$C$_y$N$_z$), le nitrure de silicium (SiN$_x$) et les mélanges d'au moins deux de ces composés. L'épaisseur $e'_1$ peut être comprise entre 50 nm et 150 nm.

Les figures 3A à 3G sont des vues en coupe, partielles et schématiques, de structures obtenues à des étapes successives d'un autre mode de réalisation du filtre interférentiel 5 de la figure 1.

Dans ce mode de réalisation, le procédé comprend les étapes successives suivantes :

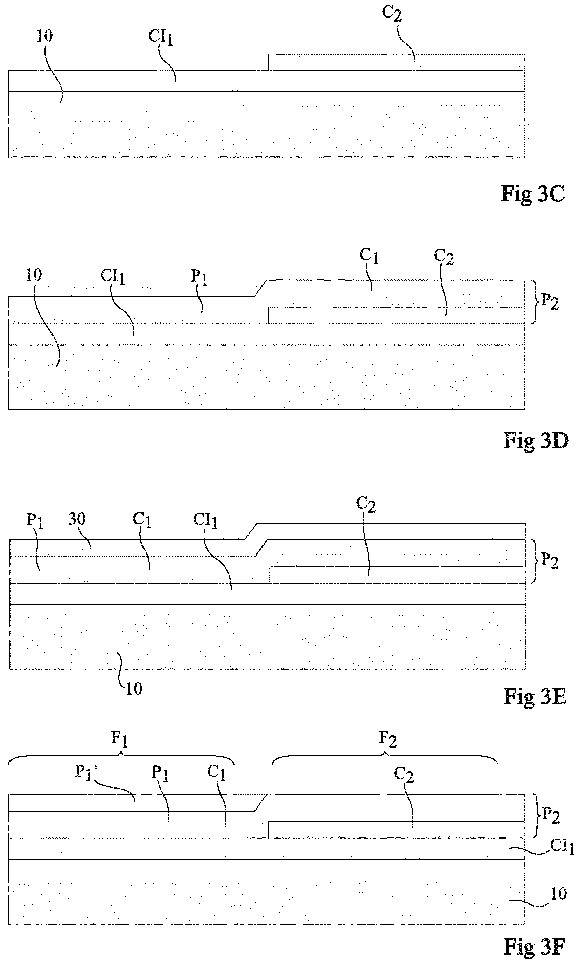

- formation de la couche d'interface $CI_1$ sur le support 10 (figure 3A) ;
- formation de la couche $C_2$ d'épaisseur $e_2-e_1$ du premier matériau diélectrique sur la première couche d'interface $CI_1$ (figure 3B) ;
- gravure de la couche $C_2$, avec arrêt de gravure sur la couche d'interface $CI_1$ à l'emplacement du premier pixel de filtre $F_1$ de façon à ne conserver la couche $C_2$ qu'à l'emplacement du deuxième pixel de filtre $F_2$ (figure 3C) ;
- formation de la couche $C_1$ d'épaisseur $e_1$ du premier matériau diélectrique sur la première couche d'interface $CI_1$ et sur la couche $C_2$ (figure 3D). Il est alors obtenu la portion $P_1$ du premier matériau diélectrique à l'emplacement du premier pixel de filtre $F_1$ et la portion $P_2$ du deuxième matériau diélectrique à l'emplacement du deuxième pixel de filtre $F_2$ ;
- formation d'une couche 30 d'épaisseur $e'_1$ du deuxième matériau diélectrique sur la couche $C_1$ (figure 3E) ;
- gravure de la couche 30, avec arrêt de gravure sur la partie de la couche $C_1$ se trouvant à l'emplacement du deuxième pixel de filtre $F_2$, ce qui délimite la portion $P'_1$ du deuxième matériau diélectrique à l'emplacement du premier pixel de filtre $F_1$ (figure 3F) ; et

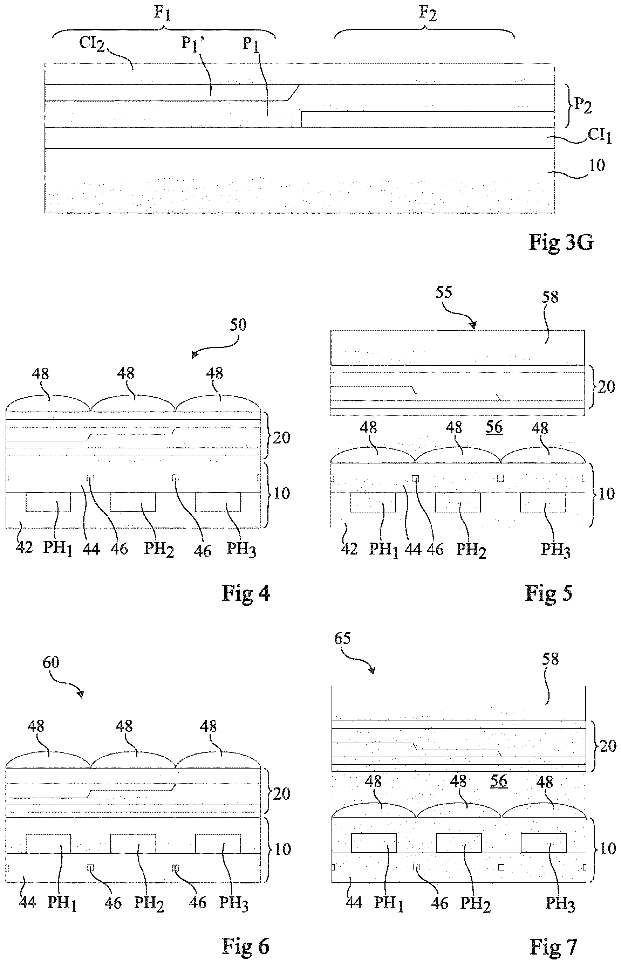

- formation de la couche d'interface $CI_2$ sur la portion $P'_1$ du deuxième matériau diélectrique et la portion $P_2$ du premier matériau diélectrique (figure 3G).

A titre de variante, il peut être prévu une couche supplémentaire, non représentée sur les figures, d'un matériau diélectrique ou métallique, recouvrant la couche d'interface $CI_1$ et jouant, par exemple, le rôle d'une couche de protection contre l'oxydation et/ou d'une couche améliorant l'adhérence des dépôts suivants. C'est cette couche qui sert alors de couche d'arrêt de gravure lors de la gravure de la couche $C_2$. A titre de variante, la formation de la couche d'interface $CI_2$ peut être précédée par la formation d'une couche supplémentaire, non représentée sur les figures, d'un matériau diélectrique ou métallique, jouant, par exemple, le rôle d'une couche améliorant l'adhérence de la couche d'interface $CI_2$.

De façon générale, dans le cas du filtre interférentiel 20 comprenant N pixels de filtre $F_1$ à $F_N$, un mode de réalisation d'un procédé de fabrication du filtre interférentiel 20 comprend les étapes suivantes :

1) formation de la couche d'interface $CI_1$ sur le support 10 ;
répétition pour i décroissant de N à 2 des étapes 2) et 3) suivantes :
2) formation de la couche $C_i$ d'épaisseur $e_i-e_{i-1}$ du premier matériau diélectrique sur la totalité de la structure ;
3) gravure de la couche $C_i$ formée à l'étape 2), avec arrêt de gravure sur la couche d'interface $CI_1$ à l'emplacement des pixels de filtre $F_1$ à $F_{i-1}$ de façon à laisser la couche $C_i$ formée à l'étape 2) aux emplacements des pixels de filtre $F_i$ à $F_N$ ;
4) formation d'une couche d'épaisseur $e'_1$ du deuxième matériau diélectrique sur la structure obtenue après la répétition des étapes 2) et 3) ;
5) gravure de la couche du deuxième matériau diélectrique, avec arrêt de gravure sur le premier matériau diélectrique à l'emplacement du pixel de filtre $F_N$ de façon à délimiter les portions $P'_1$ à $P'_{N-1}$ du deuxième matériau diélectrique à l'emplacement des pixels de filtre $F_1$ à $F_{N-1}$ ; et
6) formation de la couche d'interface $CI_2$ sur la structure obtenue à l'étape 5).

Selon un mode de réalisation, l'étape de gravure à l'étape 5) peut être une étape de polissage mécano-chimique (CMP, sigle anglais pour Chemical-Mechanical Planarization), auquel cas la couche 30 est de préférence déposée avec une épaisseur d'au moins deux fois $e'_1$. Selon un autre mode de réalisation, les étapes 5) et 6) décrites précédemment sont remplacées par une étape de dépôt d'un matériau diélectrique polymère à l'emplacement des pixels de filtre $F_1$ à $F_{N-1}$. Dans ce cas, l'étape de polissage mécano-chimique peut ne pas être présente.

De façon avantageuse, les espaceurs du filtre interférentiel 20 ont des dimensions latérales inférieures de préférence à 50 nm. Ceci permet de réduire la partie de la lumière qui parvient sur les espaceurs et donc de réduire les pertes de signal par diffusion et/ou une distorsion des réponses spectrales des pixels de filtre.

Le filtre pixélisé selon les modes de réalisation décrits précédemment peut être utilisé dans un capteur d'images.

Le capteur d'images peut alors comprendre des capteurs de photons ou photodétecteurs adaptés à détecter des rayonnements dans des plages de longueurs d'ondes différentes ou adaptés à détecter des rayonnements dans la même plage de longueurs d'ondes. Dans ce dernier cas, c'est seulement la présence des pixels de filtre qui permet la détection de rayonnements dans des plages de longueurs d'ondes différentes. Chaque pixel de filtre peut alors recouvrir au moins un photodétecteur du capteur et jouer le rôle d'un filtre passe-bande du rayonnement incident qui atteint le capteur pour fournir un rayonnement adapté à la plage de longueurs d'ondes détectées par le photodétecteur associé. Les dimensions latérales des pixels de filtre peuvent être égales aux dimensions latérales des photosites du capteur d'images ou égales à un multiple des dimensions latérales des photosites du capteur d'images. La disposition des pixels de filtre peut suivre celle des photosites du capteur d'images. A titre d'exemple, les pixels de filtre peuvent être disposés selon une matrice de Bayer. Les dimensions réduites des espaceurs du filtre interférentiel 20 permettent notamment l'utilisation du filtre interférentiel 20 avec des capteurs d'images dont les photosites ont une taille inférieure à 1,5 $\mu$m. Le capteur d'images peut être un capteur couleur ou un capteur couleur et infrarouge.

Les inventeurs ont mis en évidence que le filtre pixélisé selon les modes de réalisation décrits précédemment permet, de façon surprenante, de réaliser un filtrage dans une plage de longueurs d'ondes aussi étendue que celle nécessaire pour un capteur couleur ou un capteur couleur et infrarouge. En effet, la présence des portions $P'_i$ augmente le chemin optique de tous les pixels de filtre sauf le pixel $F_N$. Pour conserver les mêmes longueurs d'ondes filtrées par les pixels de filtre que pour un filtre pixélisé classique, il suffit de conserver le même chemin optique dans chaque pixel de filtre que pour un filtre pixélisé classique. Toutefois, un calcul simplifié montrerait, par exemple en considérant l'indice de réfraction du nitrure de silicium pour l'indice de réfraction haut $n_H$ et l'indice de réfraction du dioxyde de silicium pour l'indice de réfraction bas $n_B$, que la plage de longueurs d'ondes accessibles irait seulement du bleu au vert. Les inventeurs ont mis en évidence que les portions $P'_i$ de faible indice de réfraction $n_B$ entraînait un déphasage favorable à la réflexion sur les couches d'interface semi-réfléchissantes et qu'une plage de longueurs d'ondes allant de 450 nm à 600 nm était accessible lorsque l'écart entre l'indice de réfraction haut $n_H$ et l'indice de réfraction bas $n_B$ était supérieur ou égal à 0,5. L'ajout dans au moins un pixel de filtre d'un matériau diélectrique supplémentaire ayant un indice de réfraction supérieur à l'indice de réfraction haut $n_H$ permet d'agrandir encore la plage de longueurs d'ondes accessibles jusqu'à l'infrarouge, notamment jusqu'à la longueur d'onde 900 nm.

Le capteur peut être adapté à la détection d'une image sur une plage de longueurs d'onde donnée, par exemple dans le domaine infrarouge. Le filtre pixélisé selon les modes de réalisation décrits précédemment peut alors être utilisé pour compenser les variations de l'inclinaison du rayonnement qui atteint le capteur. Chaque pixel de filtre est alors situé à un emplacement qui dépend de l'inclinaison du rayonnement reçu par le capteur. Chaque pixel de filtre peut alors jouer le rôle d'un filtre passe-bande du rayonnement avec une inclinaison donnée centré sensiblement sur la même longueur d'onde.

Les figures 4 à 7 représentent des modes de réalisation de capteurs d'images comprenant un filtre interférentiel selon les modes de réalisation décrits précédemment.

Dans les modes de réalisation représentés sur les figures 4 à 7, le support 10 correspond à un circuit intégré comprenant un substrat 42 dans lequel et/ou sur lequel sont formés des capteurs de photons, trois capteurs de photons $PH_1$, $PH_2$, $PH_3$ étant représentés sur les figures 4 à 7. Le support 10 comprend, en outre, un empilement 44 de couches isolantes électriquement recouvrant le substrat 42 dans lequel sont formés des éléments 46 conducteurs électriquement, qui permettent notamment une connexion électrique des capteurs de photons. Dans les modes de réalisation représentés sur les figures 4 à 7, le filtre interférentiel 20 comprend, à titre d'exemple, trois pixels de filtres $F_1$, $F_2$ et $F_3$ et un seul niveau de filtre $N_1$. En outre, les capteurs d'images comprennent des lentilles 48, par exemple une lentille 48 pour chaque capteur de photons $PH_1$, $PH_2$, $PH_3$.

La figure 4 représente un mode de réalisation d'un capteur d'images 50 dans lequel le filtre interférentiel 20 est disposé du côté de l'empilement 44 opposé au substrat 42. Ce type d'agencement est appelé montage en face avant, dans la mesure où le rayonnement indicent atteint les capteurs $PH_1$, $PH_2$, $PH_3$ du côté de l'empilement 44. En figure 4, le filtre interférentiel 20 est fixé directement à l'empilement 44, par exemple par l'intermédiaire d'un matériau de collage ou de préférence, en étant déposé directement sur l'empilement 44. Dans ce mode de réalisation, les lentilles 48 reposent sur le filtre interférentiel 20, du côté du filtre interférentiel 20 opposé au support 10.

La figure 5 représente un mode de réalisation d'un capteur d'images 55 dans lequel le filtre interférentiel 20 est disposé en face avant et dans lequel les lentilles 48 sont disposées entre le support 10 et le filtre interférentiel 20 et reposent sur l'empilement 44. Un film d'air 56 est prévu entre les lentilles 48 et le filtre interférentiel 20. Le procédé de fabrication du capteur d'images 55 peut comprendre la formation du filtre interférentiel 20 sur un substrat 58 sensiblement transparent au rayonnement incident et la fixation, par exemple par collage, du filtre interférentiel 20 à l'empilement 44, le film d'air 56 étant maintenu, par exemple par l'utilisation d'une entretoise, non représentée, interposée entre l'empilement 44 et le filtre 20, à la périphérie de l'empilement 44. Selon une variante non représentée, le filtre interférentiel 20 est déposé par-dessus les lentilles 48 sans lame d'air, auquel cas il est nécessaire de planariser au préalable les lentilles 48 par le dépôt d'une couche de très bas indice de réfraction, par exemple en un polymère d'indice de réfraction 1,2.

La figure 6 représente un mode de réalisation d'un capteur d'images 60 dans lequel le filtre interférentiel 20 est disposé du côté du substrat 42. Ce type d'agencement est appelé montage en face arrière, dans la mesure où le rayonnement indicent atteint les capteurs $PH_1$, $PH_2$, $PH_3$ du côté du substrat 42. En figure 6, le filtre interférentiel 20 est fixé directement au substrat 42, éventuellement par l'intermédiaire d'un matériau de collage. Dans le présent mode de réalisation, les lentilles 48 reposent sur le filtre interférentiel 20, du côté du filtre interférentiel 20 opposé au support 10.

La figure 7 représente un mode de réalisation d'un capteur d'images 65 dans lequel le filtre interférentiel 20 est disposé en face arrière et dans lequel les lentilles 48 sont disposées entre le support 10 et le filtre interférentiel 20 et reposent sur le substrat 42. Comme pour le capteur d'images 55, un film d'air 66 est prévu entre les lentilles 48 et le filtre interférentiel 20. Le procédé de fabrication du capteur d'images 65 peut être analogue à ce qui a été décrit pour le capteur d'images 55.

Dans les modes de réalisation décrits précédemment, le capteur d'images peut comprendre une couche antireflet non représentée.

Dans les modes de réalisation décrits précédemment en relation avec les figures 5 et 7, l'utilisation du filtre interférentiel 20 est particulièrement avantageuse dans la mesure où, dans ces modes de réalisation, le rayonnement incident qui atteint le filtre interférentiel 20 n'a pas été encore focalisé par les lentilles 48 et traverse nécessairement les espaceurs entre les pixels de filtre. Les dimensions réduites de ces espaceurs améliorent le fonctionnement du capteur.

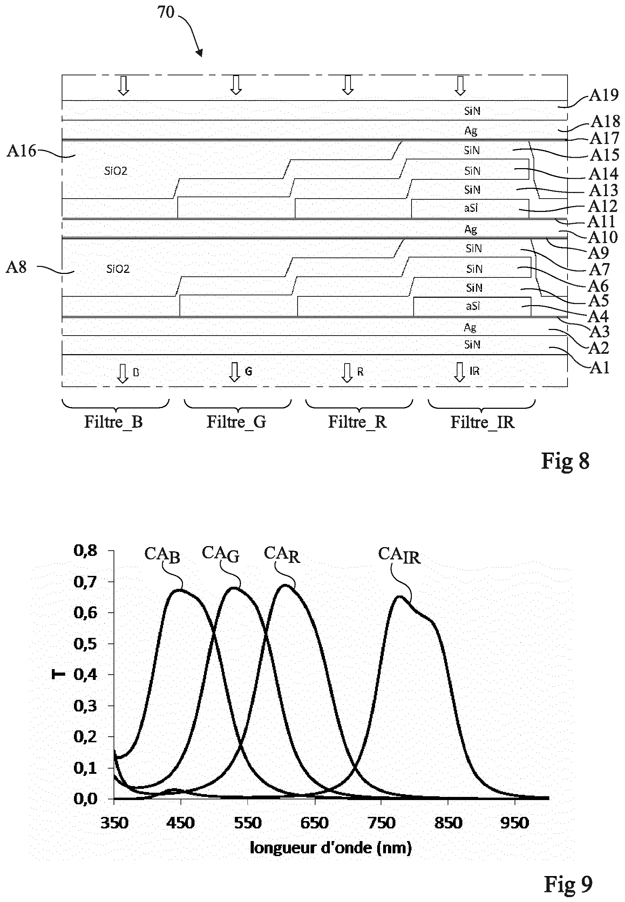

La figure 8 représente un mode de réalisation d'un filtre interférentiel 70 dont la réponse spectrale a été déterminée par simulation. Le filtre interférentiel 70 comprenait deux niveaux de filtrage $N_1$ et $N_2$, chaque niveau de filtrage comprenant quatre pixels de filtre Filtre B, Filtre G, Filtre R et Filtre_IR correspondant respectivement à un filtre laissant passer seulement la lumière bleue B, à un filtre laissant passer seulement la lumière verte G, à un filtre laissant passer seulement la lumière rouge R et à un filtre laissant passer seulement le rayonnement infrarouge IR centré sensiblement sur la longueur d'onde de 800 nm.

Les épaisseurs et les matériaux composant les couches du filtre interférentiel 70 sont regroupés dans le tableau I ci-dessous en fonction des pixels de filtre Filtre B, Filtre_G, Filtre_R et Filtre_IR. Dans la suite de la description, une couche est indiquée avec une épaisseur nulle pour un pixel de filtre donné si elle n'est pas présente pour ce pixel de filtre.

**Tableau I**

| N° couche | Matériau | Filtre_B | Filtre_ G | Filtre_R | Filtre_IR |
|---|---|---|---|---|---|
| | | Epaisseur (nm) | | | |
| A1 | SiN | 42 | | | |
| A2 | Ag | 22 | | | |
| A3 | $TiO_2$ | 5 | | | |
| A4 | aSi | 0 | 0 | 0 | 25 |
| A5 | SiN | 0 | 0 | 33 | 33 |
| A6 | SiN | *0 | 32 | 32 | 32 |
| A7 | SiN | 6 | 6 | 6 | 6 |
| A8 | $SiO_2$ | 91 | 59 | 25 | 0 |
| A9 | SiN | 5 | | | |
| A10 | Ag | 33 | | | |
| A11 | $TiO_2$ | 5 | | | |
| A12 | aSi | 0 | 0 | 0 | 25 |
| A13 | SiN | 0 | 0 | 33 | 33 |
| A14 | SiN | 0 | 32 | 32 | 32 |
| A15 | SiN | 6 | 6 | 6 | 6 |
| A16 | $SiO_2$ | 91 | 59 | 25 | 0 |
| A17 | SiN | 5 | | | |
| A18 | Ag | 16 | | | |
| A19 | SiN | 46 | | | |

Le filtre 70 a été fabriqué en déposant successivement chaque couche A1 à A19 et en gravant les couches A4 à A6 et A12 à A14 aux emplacements où elles ne sont pas présentes et en prévoyant une étape de planarisation après le dépôt des couches A8 et A16 jusqu'à atteindre les couches sous-jacentes.

Les couches A3 et A11 de $TiO_2$ servent à la fois d'encapsulation de la couche d'Ag A2 et A10 sous-jacente respectivement et de couche d'arrêt de gravure lors de la gravure des couches de aSi et SiN ultérieures. L'indice de réfraction du SiN sur la plage de longueur d'onde de 450 nm à 600 nm est sensiblement constant et égal à 2,0 et l'indice de réfraction du $SiO_2$ sur la plage de longueur d'onde de 450 nm à 600 nm est sensiblement constant et égal à 1,46. L'indice de réfraction du silicium amorphe (aSi) sur la plage de longueur d'onde de l'infrarouge est sensiblement constant et égal à 3,7. L'épaisseur totale du filtre 70 était de 0,37 $\mu$m. L'épaisseur du filtre 70 étant faible par rapport à la taille des pixels, le phénomène de diaphonie optique est peu prononcé.

La figure 9 représente des courbes d'évolution de la transmission respectivement du pixel de filtre Filtre B (courbe $CA_B$), du pixel de filtre Filtre_G (courbe $CA_G$), du pixel de filtre Filtre_R (courbe $CA_R$) et du pixel de filtre Filtre_IR (courbe $CA_{IR}$) pour le filtre interférentiel 70.

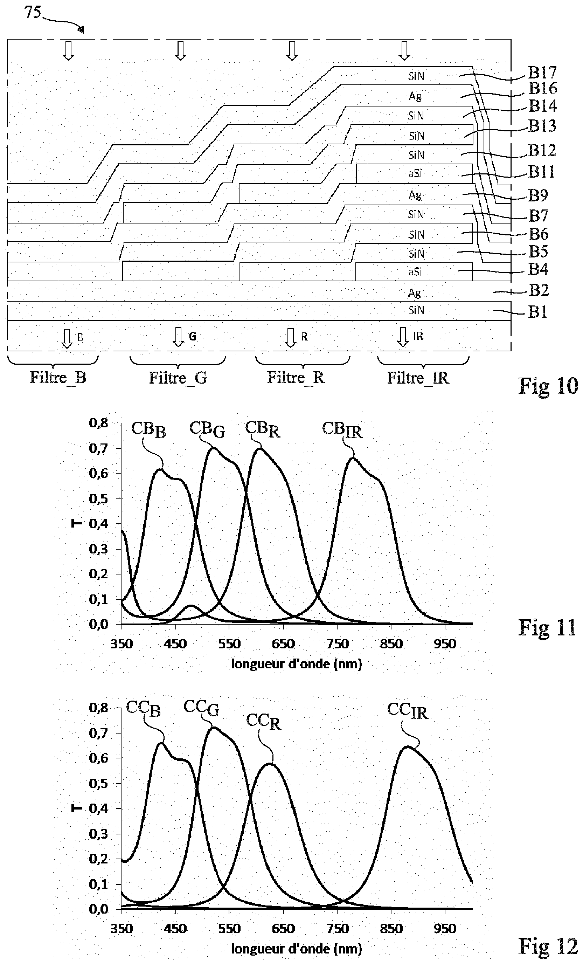

La figure 10 représente un exemple de comparaison d'un filtre interférentiel 75 dont la réponse spectrale a été déterminée par simulation. Le filtre interférentiel 75 avait la même structure que le filtre 70 à la différence que les couches de $SiO_2$ A8 et A16 n'étaient pas présentes et que les épaisseurs des autres couches pouvaient être modifiées.

Les épaisseurs et les matériaux composant les couches du filtre interférentiel 75 sont regroupés dans le tableau II ci-dessous en fonction des pixels de filtre Filtre_B, Filtre_G, Filtre_R et Filtre_IR.

**Tableau II**

| N° couche | Matériau | Filtre_B | Filtre_G | Filtre_R | Filtre_IR |
|---|---|---|---|---|---|
| | | Epaisseur (nm) | | | |
| B1 | SiN | 41 | | | |
| B2 | Ag | 22 | | | |
| B3 | TiO$_2$ | 5 | | | |
| B4 | aSi | 0 | 0 | 0 | 19 |
| B5 | SiN | 0 | 0 | 20 | 20 |
| B6 | SiN | 0 | 24 | 24 | 24 |
| B7 | SiN | 48 | 48 | 48 | 48 |
| B8 | SiN | 5 | | | |
| B9 | Ag | 33 | | | |
| B10 | TiO$_2$ | 5 | | | |
| B11 | aSi | 0 | 0 | 0 | 20 |
| B12 | SiN | 0 | 0 | 21 | 21 |
| B13 | SiN | 0 | 26 | 26 | 26 |
| B14 | SiN | 47 | 47 | 47 | 47 |
| B15 | SiN | 5 | | | |
| B16 | Ag | 17 | | | |
| B17 | SiN | 70 | | | |

Le filtre 75 a été fabriqué en déposant successivement chaque couche A1 à A19 et en gravant les couches B4 à B6 et B11 à B13 aux emplacements où elles ne sont pas présentes.

La figure 11 représente des courbes d'évolution de la transmission respectivement du pixel de filtre Filtre_B (courbe CB$_B$), du pixel de filtre Filtre_G (courbe CB$_G$), du pixel de filtre Filtre_R (courbe CB$_R$) et du pixel de filtre Filtre_IR (courbe CB$_{IR}$) pour le filtre interférentiel 75. Les courbes de transmission du filtre 70 sont sensiblement identiques aux courbes de transmission du filtre 75. Les réponses spectrales des filtres 70 et 75 sont donc sensiblement identiques. Toutefois, la dimension latérale maximale des espaceurs du filtre 75 est supérieure à celle des espaceurs du filtre 70. En effet, entre les pixels de filtre Filtre_IR et Filtre_R, la dimension latérale maximale des espaceurs du filtre 75 est par exemple de l'ordre de 250 nm alors qu'elle est de l'ordre de 50 nm pour le filtre 70.

Le filtre 70 est donc particulièrement adapté à une utilisation avec un capteur d'images dont la taille des photosites est inférieure au micromètre.

Il est possible de centrer le pixel de filtre Filtre_IR à une longueur d'onde supérieure à celle du filtre 70 décrit précédemment, par exemple en introduisant une couche de aSi dans le pixel de filtre Filtre_R. Le remplacement d'une couche de SiN par une couche de aSi de plus haut indice de réfraction dans le pixel de filtre Filtre_R permet de réduire l'épaisseur de la marche entre le pixel de filtre Filtre_G et le pixel de filtre Filtre_R, et la différence d'épaisseur peut être utilisée pour décaler le pixel filtre Filtre_IR vers les hautes longueurs d'onde. Toutefois, comme l'épaisseur totale de chaque pixel de filtre doit être maintenue identique à celle du filtre Filtre_B, l'épaisseur du pixel de filtre Filtre_IR ne peut pas être indéfiniment augmentée.

La réponse spectrale d'un tel filtre interférentiel a été déterminée par simulation avec du aSi dans les pixels de filtres Filtre_IR et Filtre_R. L'empilement du filtre a une épaisseur totale de 0,39 μm, les hauteurs de marche entre le pixel de filtre Filtre_B et le pixel de filtre Filtre_G, entre le pixel de filtre Filtre_G et le pixel de filtre Filtre_R et entre le pixel de filtre Filtre_R et le pixel de filtre Filtre_IR étaient respectivement de 38 nm, 8 nm, et 38 nm. La largeur maximale des espaceurs est par exemple de l'ordre de 60 nm aux transitions entre le pixel de filtre Filtre_R et le pixel de filtre Filtre_IR.

Les épaisseurs et les matériaux composant les couches du filtre interférentiel sont regroupés dans le tableau III ci-dessous en fonction des pixels de filtre Filtre_B, Filtre_G, Filtre_R et Filtre_IR.

**Tableau III**

| N° couche | Matériau | Filtre B | Filtre G | Filtre R | Filtre IR |
|-----------|----------|----------|----------|----------|-----------|
| | | Epaisseur (nm) | | | |
| C1 | SiN | 75 | | | |
| C2 | Ag | 18 | | | |
| C3 | TiO$_2$ | 5 | | | |
| C4 | aSi | 0 | 0 | 0 | 38 |
| C5 | aSi | 0 | 0 | 8 | 8 |
| C6 | SiN | 0 | 38 | 38 | 38 |
| C7 | SiN | 5 | 5 | 5 | 5 |
| C8 | SiO$_2$ | 85 | 47 | 38 | 0 |
| C9 | SiN | 5 | | | |
| C10 | Ag | 31 | | | |
| C11 | TiO$_2$ | 5 | | | |
| C12 | aSi | 0 | 0 | 0 | 38 |
| C13 | aSi | 0 | 0 | 8 | 8 |
| C14 | SiN | 0 | 38 | 38 | 38 |
| C15 | SiN | 5 | 5 | 5 | 5 |
| C16 | SiO$_2$ | 85 | 47 | 38 | 0 |
| C17 | SiN | 5 | | | |
| C18 | Ag | 16 | | | |
| C19 | SiN | 47 | | | |

La figure 12 représente des courbes d'évolution de la transmission respectivement du pixel de filtre Filtre_B (courbe CC$_B$), du filtre Filtre_G (courbe CC$_G$), du filtre Filtre_R (courbe CC$_R$) et du filtre Filtre_IR (courbe CC$_{IR}$) pour le filtre interférentiel défini par le tableau III. Un pixel de filtre Filtre_IR centré sur une longueur d'onde de 900 nm environ a été obtenu.

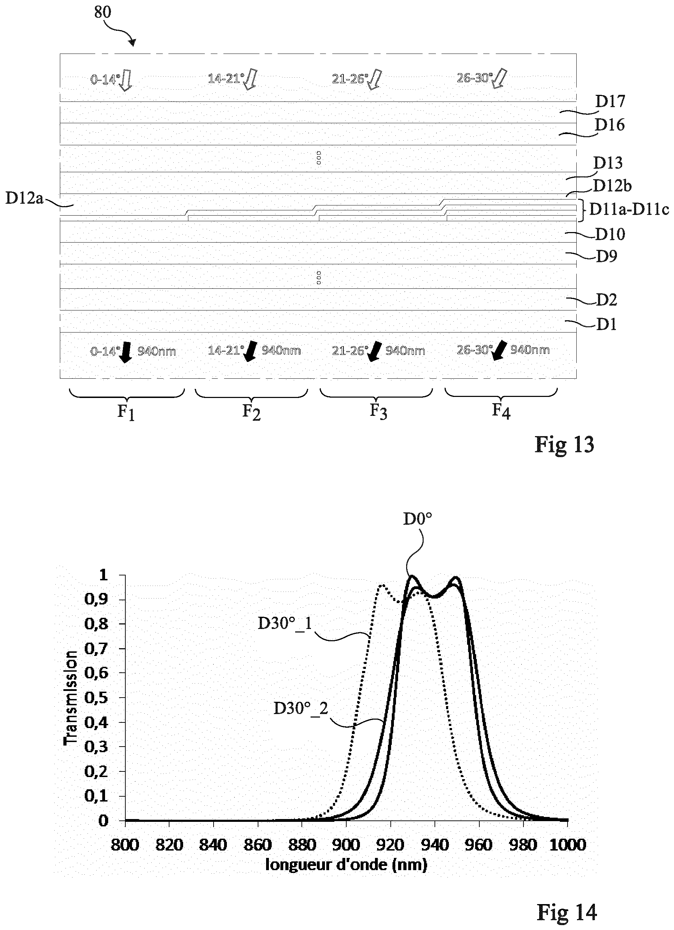

La figure 13 représente un mode de réalisation d'un filtre interférentiel 80 à compensation du décalage spectral sous incidence spatialement variable dont la réponse spectrale a été déterminée par simulation. Le filtre interférentiel 80 comprenait quatre pixels de filtre F$_1$, F$_2$, F$_3$ et F$_4$. Les pixels de filtre F$_1$, F$_2$, F$_3$ et F$_4$ sont destinés à recevoir un rayonnement ayant une incidence respectivement comprise entre 0° et 14°, entre 14° et 21°, entre 21° et 26° et entre 26° et 30°.

Les épaisseurs et les matériaux composant les couches du filtre interférentiel 80 sont regroupés dans le tableau IV ci-dessous en fonction des pixels de filtre.

**Tableau IV**

| N° couche | Matériau | Filtre B | Filtre G | Filtre R | Filtre IR |
|-----------|----------|----------|----------|----------|-----------|
| | | Epaisseur (nm) | | | |
| D1 | aSi | 85 | | | |
| D2 | SiO$_2$ | 34 | | | |
| D3 | aSi | 162 | | | |
| D4 | SiO$_2$ | 142 | | | |
| D5 | aSi | 68 | | | |
| D6 | SiO$_2$ | 172 | | | |

(suite)

| N° couche | Matériau | Filtre B | Filtre G | Filtre R | Filtre IR |
|---|---|---|---|---|---|
| | | Epaisseur (nm) | | | |
| D7 | aSi | 56 | | | |
| D8 | SiO$_2$ | 19 | | | |
| D9 | aSi | 321 | | | |
| D10 | SiO$_2$ | 169 | | | |
| D11a | aSi | 0 | 0 | 0 | 19 |
| D11b | aSi | 0 | 0 | 19 | 19 |
| D11c | aSi | 0 | 19 | 19 | 19 |
| D11d | aSi | 33 | 33 | 33 | 33 |
| D11e | SiN | 10 | 10 | 10 | 10 |
| D12a | SiO$_2$ | 57 | 38 | 19 | 0 |
| D12b | SiO$_2$ | 131 | | | |
| D13 | aSi | 99 | | | |
| D14 | SiO$_2$ | 46 | | | |
| D15 | aSi | 161 | | | |
| D16 | SiO$_2$ | 62 | | | |
| D17 | aSi | 97 | | | |

Le filtre 80 a été fabriqué en déposant successivement chaque couche D1 à D17 et en gravant les couches D11a à D11c aux emplacements où elles ne sont pas présentes et en prévoyant une étape de planarisation après le dépôt de la couche D12a jusqu'à atteindre la couche sous-jacente.

La figure 14 représente des courbes d'évolution, pour le filtre 80, de la transmission respectivement du pixel de filtre $P_1$ recevant un rayonnement sous incidence nulle (courbe D0°), du pixel de filtre $P_1$ recevant un rayonnement sous incidence égale à 30° (courbe D30°_1) et du pixel de filtre $P_4$ recevant un rayonnement sous incidence égale à 30° (courbe D30°_2). La réponse spectrale du pixel de filtre $P_4$ est sensiblement centrée sur 940 nm comme la réponse spectrale du pixel de filtre $P_1$.

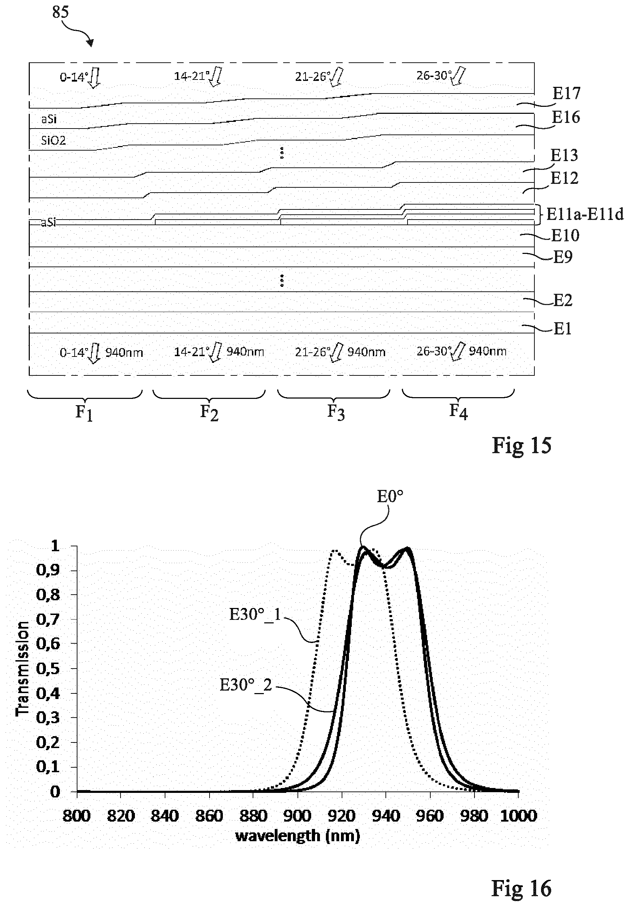

La figure 15 représente un exemple de comparaison d'un filtre interférentiel 85 à compensation du décalage spectral sous incidence spatialement variable dont la réponse spectrale a été déterminée par simulation. Le filtre interférentiel 85 avait la même structure que le filtre 80 à la différence que la couche de SiO$_2$ D12a n'était pas présente et que les épaisseurs des autres couches pouvaient être modifiées.

Les épaisseurs et les matériaux composant les couches du filtre interférentiel 80 sont regroupés dans le tableau IV ci-dessous en fonction des pixels de filtre.

**Tableau IV**

| N° couche | Matériau | Filtre B | Filtre G | Filtre R | Filtre IR |
|---|---|---|---|---|---|
| | | Epaisseur (nm) | | | |
| E1 | aSi | 85 | | | |
| E2 | SiO$_2$ | 33 | | | |
| E3 | aSi | 162 | | | |
| E4 | SiO$_2$ | 147 | | | |
| E5 | aSi | 65 | | | |
| E6 | SiO$_2$ | 150 | | | |
| E7 | aSi | 95 | | | |

(suite)

| N° couche | Matériau | Filtre B | Filtre G | Filtre R | Filtre IR |
|---|---|---|---|---|---|
| | | Epaisseur (nm) | | | |
| E8 | $SiO_2$ | 10 | | | |
| E9 | aSi | 302 | | | |
| E10 | $SiO_2$ | 163 | | | |
| E11a | aSi | 0 | 0 | 0 | 16 |
| E11b | aSi | 0 | 0 | 16 | 16 |
| E11c | aSi | 0 | 16 | 16 | 16 |
| E11d | aSi | 45 | 45 | 45 | 45 |
| E12 | $SiO_2$ | 144 | | | |
| E13 | aSi | 103 | | | |
| E14 | $SiO_2$ | 45 | | | |
| E15 | aSi | 158 | | | |
| E16 | $SiO_2$ | 72 | | | |
| E17 | aSi | 95 | | | |

Le filtre 85 a été fabriqué en déposant successivement chaque couche E1 à E17 et en gravant les couches Ella à E11c aux emplacements où elles ne sont pas présentes.

La figure 16 représente des courbes d'évolution, pour le filtre 85, de la transmission respectivement du pixel de filtre $P_1$ recevant un rayonnement sous incidence nulle (courbe E0°), du pixel de filtre $P_1$ recevant un rayonnement sous incidence égale à 30° (courbe E30°_1) et du pixel de filtre $P_4$ recevant un rayonnement sous incidence égale à 30° (courbe E30°_2). La réponse spectrale du pixel de filtre $P_4$ est sensiblement centrée sur 940 nm comme la réponse spectrale du pixel de filtre $P_1$.

Les courbes de transmission du filtre 85 sont sensiblement identiques aux courbes de transmission du filtre 80. Les réponses spectrales des filtres 85 et 80 sont donc sensiblement identiques.

Pour le filtre 85, la hauteur de marche entre les pixels de filtre $F_3$ et $F_4$ pour les couches Ella à E11c est de 16 nm. Toutefois, cette structure est recouverte par six couches d'épaisseur totale égale à 660 nm, ce qui génère un espaceur dont la dimension latérale est de l'ordre de 500 nm au-dessus de chaque marche entre les pixels de filtre $F_3$ et $F_4$. Comme l'espaceur est nettement plus large que la hauteur de marche, le relief se lisse au fur et à mesure des six derniers dépôts. Toutefois, il n'est alors pas possible de maîtriser avec précision les épaisseurs déposées dans les zones de transition. De ce fait, les signaux mesurés sur les pixels de l'imageur sous la matrice de filtre, en regard des marches, peuvent être perturbés, jusqu'à des tailles de pixels de plusieurs micromètres.

Pour le filtre 80, la hauteur de marche entre les pixels de filtre $F_3$ et $F_4$ pour les couches D11a à D11c est de 19 nm. Toutefois, les couches ultérieures D12b à D17 sont déposées sur une surface plane. La dimension latérale maximale des espaceurs du filtre 85 est de l'ordre de 50 nm, c'est-à-dire inférieure à celle du filtre 85.

Divers modes de réalisation avec diverses variantes ont été décrits ci-dessus. On note que l'homme de l'art peut combiner divers éléments de ces divers modes de réalisation et variantes sans faire preuve d'activité inventive.

**Revendications**

1. Filtre interférentiel (20) comprenant sur un support (10) :

une première couche d'interface ($CI_1$) plane, métallique ou comprenant un empilement d'au moins deux couches diélectriques avec une différence d'indices de réfraction supérieure ou égale à 0,5 ;
N portions diélectriques ($P_i$) d'un premier matériau diélectrique ou de premiers matériaux diélectriques reposant sur la première couche d'interface, où N est un nombre entier supérieur ou égal à 2, la $i^{ème}$ portion diélectrique du premier matériau diélectrique ou des premiers matériaux diélectriques, où i est un nombre entier qui varie de 1 à N, comprenant un empilement de i couches du premier matériau diélectrique ou des premiers matériaux diélectriques, l'épaisseur de la $j^{\text{ème}}$ portion diélectrique du premier matériau diélectrique ou des premiers matériaux diélectriques, où j est un nombre entier qui varie de 1 à N-1, étant inférieure à l'épaisseur de la $k^{\text{ème}}$ portion diélectrique du premier matériau diélectrique ou des premiers matériaux diélectriques, où k est égal à j+1 ; N-1 portions diélectriques $(P'_i)$ d'un deuxième matériau diélectrique, l'indice de réfraction du deuxième matériau à une longueur d'onde de fonctionnement du filtre étant inférieur à l'indice de réfraction du premier matériau ou des premiers matériaux à ladite longueur d'onde, la $j^{\text{ème}}$ portion diélectrique du deuxième matériau diélectrique reposant sur la $j^{\text{ème}}$ portion diélectrique du premier matériau diélectrique ou des premiers matériaux diélectriques, la somme de l'épaisseur de la $j^{\text{ème}}$ portion diélectrique du deuxième matériau diélectrique et de l'épaisseur de la $j^{\text{ème}}$ portion diélectrique du premier matériau diélectrique ou des premiers matériaux diélectriques étant égale à l'épaisseur de la $N^{\text{ème}}$ portion diélectrique du premier matériau diélectrique ou des premiers matériaux diélectriques ; et

une deuxième couche d'interface $(CI_2)$ plane, métallique ou comprenant un empilement d'au moins deux couches diélectriques avec une différence d'indices de réfraction supérieure ou égale à 0,5, reposant sur les portions diélectriques du deuxième matériau diélectrique $(P'_i)$ et la $N^{\text{ème}}$ portion diélectrique du premier matériau diélectrique ou des premiers matériaux diélectriques $(P_N)$, au contact des portions diélectriques du deuxième matériau diélectrique et de la $N^{\text{ème}}$ portion diélectrique du premier matériau diélectrique ou des premiers matériaux diélectriques,

le filtre interférentiel comprenant, pour chaque $j^{\text{ème}}$ et $k^{\text{ème}}$ portion diélectrique du premier matériau diélectrique ou des premiers matériaux diélectriques, une zone de transition entre les $j^{\text{ème}}$ et $k^{\text{ème}}$ portions diélectriques du premier matériau diélectrique ou des premiers matériaux diélectriques, l'épaisseur de la zone de transition variant de l'épaisseur de la $j^{\text{ème}}$ portion diélectrique du premier matériau diélectrique ou des premiers matériaux diélectriques à l'épaisseur de la $k^{\text{ème}}$ portion diélectrique du premier matériau diélectrique ou des premiers matériaux diélectriques, la dimension latérale maximale de la zone de transition, mesurée orthogonalement à la direction d'empilement, étant inférieure à 50 nm.

2.  Filtre interférentiel selon la revendication 1, dans lequel N est supérieur ou égal à 3.

3.  Filtre interférentiel selon la revendication 2, dans lequel N est supérieur ou égal à 4.

4.  Filtre interférentiel selon l'une quelconque des revendications 1 à 3, dans lequel le premier matériau diélectrique ou les premiers matériaux diélectriques sont choisis parmi le groupe comprenant le nitrure de silicium (SiN), le silicium amorphe (aSi), l'oxyde d'hafnium $(HfO_x)$, l'oxyde d'aluminium $(AlO_x)$, un film à base d'aluminium, d'oxygène et d'azote $(AlO_xN_y)$, un film à base de silicium, d'oxygène, de carbone et d'azote $(SiO_xC_yN_z)$, le nitrure de silicium $(SiN_x)$, l'oxyde de niobium $(NbO_x)$, l'oxyde de tantale $(TaO_x)$, l'oxyde de titane $(TiO_x)$, le silicium amorphe hydrogéné (aSiH) et les mélanges d'au moins deux de ces composés.

5.  Filtre interférentiel selon l'une quelconque des revendications 1 à 4, dans lequel le deuxième matériau diélectrique est choisi parmi le groupe comprenant le dioxyde de silicium $(SiO_2)$, le fluorure de magnésium $(MgF_2)$, l'oxyde de silicium $(SiO_x)$, l'oxynitrure de silicium $(SiO_xN_y)$, l'oxyde d'hafnium $(HfO_x)$, l'oxyde d'aluminium $(AlO_x)$, un film à base d'aluminium, d'oxygène et d'azote $(AlO_xN_y)$, un film à base de silicium, d'oxygène, de carbone et d'azote $(SiO_xC_yN_z)$, le nitrure de silicium $(SiN_x)$ et les mélanges d'au moins deux de ces composés.

6.  Capteur d'images (50 ; 55 ; 60 ; 65) comprenant le filtre interférentiel selon l'une quelconque des revendications 1 à 5 et dans lequel le filtre interférentiel (20) comprend un premier filtre élémentaire $(F_1)$ comprenant la $1^{\text{ère}}$ portion $(P_1)$ du premier matériau diélectrique ou des premiers matériaux diélectriques et la $1^{\text{ère}}$ portion $(P'_1)$ du deuxième matériau diélectrique et un deuxième filtre élémentaire $(F_2)$ comprenant la $2^{\text{ème}}$ portion $(P_2)$ du premier matériau diélectrique ou des premiers matériaux diélectriques.

7.  Capteur d'images selon la revendication 6, dans lequel le capteur est un capteur d'images couleur, dans lequel le premier filtre élémentaire $(F_1)$ est un filtre passe-bande centré sur une première longueur d'onde et dans lequel le deuxième filtre élémentaire $(F_2)$ est un filtre passe-bande centré sur une deuxième longueur d'onde.

8.  Capteur d'images selon la revendication 7, dans lequel le capteur est un capteur d'images couleur, dans lequel le premier filtre élémentaire $(F_1)$ est un filtre passe-bande centré sur une troisième longueur d'onde pour un rayonnement à une première incidence par rapport au filtre interférentiel (20) et dans lequel le deuxième filtre élémentaire $(F_2)$ est un filtre passe-bande centré sur la troisième longueur d'onde à 1 % près pour le rayonnement à une deuxième incidence par rapport au filtre interférentiel (20).

9.  Procédé de fabrication d'un filtre interférentiel (20) selon l'une quelconque des revendications 1 à 5, comprenant les étapes successives suivantes :

> a) dépôt sur le support (10) d'une première couche diélectrique ($C_N$) du premier matériau diélectrique ou des premiers matériaux diélectriques sur la première couche d'interface ($CI_1$) ;
> b) gravure de la première couche diélectrique pour retirer la première couche diélectrique à un premier emplacement et conserver la première couche à un deuxième emplacement ;
> c) dépôt d'une deuxième couche ($C_2$) du premier matériau diélectrique ou des premiers matériaux diélectriques sur la première couche d'interface au premier emplacement et sur la première couche diélectrique au deuxième emplacement ; et
> d) formation de la portion ($P'_1$) du deuxième matériau diélectrique sur la deuxième couche au premier emplacement.

10. Procédé selon la revendication 9, dans lequel l'étape d) comprend les étapes suivantes :

> dépôt d'une troisième couche diélectrique (30) du deuxième matériau diélectrique sur la deuxième couche ($C_2$) ; et
>
> gravure de la troisième couche diélectrique jusqu'à atteindre la deuxième couche diélectrique ($C_2$) au deuxième emplacement.

11. Procédé selon la revendication 10, dans lequel la gravure de la troisième couche diélectrique (30) comprend une étape de polissage mécano-chimique.

**Patentansprüche**

1.  Ein Interferenzfilter (20), der auf einem Träger (10) Folgendes aufweist:

> eine erste planare Grenzflächenschicht ($CI_1$), die metallisch ist oder einen Stapel aus mindestens zwei dielektrischen Schichten mit einer Differenz zwischen den Brechungsindizes von größer oder gleich 0,5 aufweist;
> N dielektrische Teile ($P_i$) eines ersten dielektrischen Materials oder von ersten dielektrischen Materialien, die auf der ersten Grenzflächenschicht liegen, wobei N eine ganze Zahl größer oder gleich 2 ist, wobei der i-te dielektrische Teil des ersten dielektrischen Materials oder der ersten dielektrischen Materialien, wobei i eine ganze Zahl im Bereich von 1 bis N ist, einen Stapel von i Schichten aus dem ersten dielektrischen Material oder aus den ersten dielektrischen Materialien aufweist, wobei die Dicke des j-ten dielektrischen Teils des ersten dielektrischen Materials oder der ersten dielektrischen Materialien, wobei j eine ganze Zahl im Bereich von 1 bis N-1 ist, kleiner ist als die Dicke des k-ten dielektrischen Teils des ersten dielektrischen Materials oder der ersten dielektrischen Materialien, wobei k gleich j+1 ist;
> N-1 dielektrische Teile ($P'_i$) eines zweiten dielektrischen Materials, wobei der Brechungsindex des zweiten Materials bei einer Betriebswellenlänge des Filters kleiner ist als der Brechungsindex des ersten Materials oder der ersten Materialien bei dieser Wellenlänge, wobei der j-te dielektrische Teil des zweiten dielektrischen Materials auf dem j-ten dielektrischen Teil des ersten dielektrischen Materials oder der ersten dielektrischen Materialien liegt, wobei die Summe der Dicke des j-ten dielektrischen Teils des zweiten dielektrischen Materials und der Dicke des j-ten dielektrischen Teils des ersten dielektrischen Materials oder der ersten dielektrischen Materialien gleich der Dicke des N-ten dielektrischen Teils des ersten dielektrischen Materials oder der ersten dielektrischen Materialien ist; und
> eine zweite planare Grenzflächenschicht ($CI_2$), die metallisch ist oder einen Stapel aus mindestens zwei dielektrischen Schichten mit einer Differenz zwischen Brechungsindizes größer oder gleich 0,5 aufweist, die auf den dielektrischen Teilen des zweiten dielektrischen Materials ($P'_i$) und dem N-ten dielektrischen Teil des ersten dielektrischen Materials oder der ersten dielektrischen Materialien ($P_N$) liegt, und zwar in Kontakt mit den dielektrischen Teilen des zweiten dielektrischen Materials und dem N-ten dielektrischen Teil des ersten dielektrischen Materials oder der ersten dielektrischen Materialien,
> wobei das Interferenzfilter für jeden j-ten und k-ten dielektrischen Teil des ersten dielektrischen Materials oder der ersten dielektrischen Materialien einen Übergangsbereich zwischen dem j-ten und k-ten dielektrischen Teil des ersten dielektrischen Materials oder der ersten dielektrischen Materialien aufweist, wobei die Dicke des Übergangsbereichs variiert, und zwar von der Dicke des j-ten dielektrischen Teils des ersten dielektrischen Materials oder der ersten dielektrischen Materialien bis zur Dicke des k-ten dielektrischen Teils des ersten dielektrischen Materials oder der ersten dielektrischen Materialien, wobei die maximale seitliche Abmessung des Übergangsbereichs, gemessen orthogonal zur Stapelrichtung, kleiner als 50 nm ist.

2. Interferenzfilter nach Anspruch 1, wobei N größer oder gleich 3 ist.

3. Interferenzfilter nach Anspruch 2, wobei N größer oder gleich 4 ist.

4. Interferenzfilter nach einem der Ansprüche 1 bis 3, wobei das erste dielektrische Material oder die ersten dielektrischen Materialien aus der Gruppe ausgewählt sind, die Folgendes aufweist: Siliziumnitrid (SiN), amorphes Silizium (aSi), Hafniumoxid ($HfO_x$), Aluminiumoxid ($AlO_x$), einen Film aus Aluminium, Sauerstoff und Stickstoff ($AlO_xN_y$), einem Film aus Silizium, Sauerstoff, Kohlenstoff und Stickstoff ($SiO_xC_yN_z$), Siliziumnitrid ($SiN_x$), Nioboxid ($NbO_x$), Tantaloxid ($TaO_x$), Titanoxid ($TiO_x$), hydriertem amorphem Silizium (aSiH) und Mischungen aus mindestens zwei dieser Verbindungen.

5. Interferenzfilter nach einem der Ansprüche 1 bis 4, wobei das zweite dielektrische Material aus der Gruppe ausgewählt ist, die Folgendes aufweist: Siliziumdioxid ($SiO_2$), Magnesiumfluorid ($MgF_2$), Siliziumoxid ($SiO_x$), Siliziumoxynitrid ($Si-O_xN_y$), Hafniumoxid ($HfO_x$), Aluminiumoxid ($AlO_x$), eine Schicht aus Aluminium, Sauerstoff und Stickstoff ($AlO_xN_y$), eine Schicht aus Silizium, Sauerstoff, Kohlenstoff und Stickstoff ($SiO_xC_yN_z$), Siliziumnitrid ($SiN_x$) und Mischungen aus mindestens zwei dieser Verbindungen.

6. Bildsensor (50; 55; 60; 65) mit einem Interferenzfilter nach einem der Ansprüche 1 bis 5, wobei das Interferenzfilter (20) ein erstes Elementarfilter ($F_1$), das den ersten Teil ($P_1$) aus dem ersten dielektrischen Material oder aus den ersten dielektrischen Materialien und den ersten Teil ($P'_1$) aus dem zweiten dielektrischen Material aufweist, und ein zweites Elementarfilter ($F_2$), das den zweiten Teil ($P_2$) aus dem ersten dielektrischen Material oder aus den ersten dielektrischen Materialien aufweist, aufweist.

7. Bildsensor nach Anspruch 6, wobei der Sensor ein Farbbildsensor ist, wobei das erste Elementarfilter ($F_1$) ein Bandpassfilter ist, das auf eine erste Wellenlänge zentriert ist, und wobei das zweite Elementarfilter ($F_2$) ein Bandpassfilter ist, das auf eine zweite Wellenlänge zentriert ist.

8. Bildsensor nach Anspruch 7, wobei der Sensor ein Farbbildsensor ist, wobei das erste Elementarfilter ($F_1$) ein Bandpassfilter ist, das auf eine dritte Wellenlänge für eine Strahlung bei einem ersten Einfall relativ zum Interferenzfilter (20) zentriert ist, und wobei das zweite Elementarfilter ($F_2$) ein Bandpassfilter ist, das auf die dritte Wellenlänge mit einer Genauigkeit von 1% für die Strahlung bei einem zweiten Einfall relativ zum Interferenzfilter (20) zentriert ist.

9. Verfahren zur Herstellung des Interferenzfilters (20) nach einem der Ansprüche 1 bis 5, wobei das Verfahren die folgenden aufeinanderfolgenden Schritte aufweist:

a) Abscheiden einer ersten dielektrischen Schicht ($C_N$) aus dem ersten dielektrischen Material oder aus den ersten dielektrischen Materialien auf der ersten Grenzflächenschicht ($CI_1$) auf dem Träger (10);
b) Ätzen der ersten dielektrischen Schicht, um die erste dielektrische Schicht von einer ersten Stelle zu entfernen und die erste Schicht an einer zweiten Stelle zu behalten;
c) Abscheiden einer zweiten Schicht ($C_2$) aus dem ersten dielektrischen Material oder aus den ersten dielektrischen Materialien auf der ersten Grenzflächenschicht an der ersten Stelle und auf der ersten dielektrischen Schicht an der zweiten Stelle; und
d) Bilden des Teils ($P'_1$) des zweiten dielektrischen Materials auf der zweiten Schicht an der ersten Stelle.

10. Verfahren nach Anspruch 9, wobei Schritt d) die folgenden Schritte aufweist:

Abscheiden einer dritten dielektrischen Schicht (30) des zweiten dielektrischen Materials auf der zweiten Schicht ($C_2$); und
Ätzen der dritten dielektrischen Schicht bis zum Erhalten der zweiten dielektrische Schicht ($C_2$) an der zweiten Stelle.

11. Verfahren nach Anspruch 10, wobei das Ätzen der dritten dielektrischen Schicht (30) einen chemisch-mechanischen Polierschritt aufweist.

**Claims**

1. An interference filter (20) comprising on a support (10) :

   a first planar interface layer ($CI_1$), metallic or comprising a stack of at least two dielectric layers with a difference between refraction indexes greater than or equal to 0.5;
   N dielectric portions ($P_i$) of a first dielectric material or of first dielectric materials resting on the first interface layer, where N is an integer greater than or equal to 2, the $i^{th}$ dielectric portion of the first dielectric material or of the first dielectric materials, where i is an integer in the range from 1 to N, comprising a stack of i layers of the first dielectric material or of the first dielectric materials, the thickness of the $j^{th}$ dielectric portion of the first dielectric material or of the first dielectric materials, where j is an integer in the range from 1 to N-1, being smaller than the thickness of the $k^{th}$ dielectric portion of the first dielectric material or of the first dielectric materials, where k is equal to j+1;
   N-1 dielectric portions ($P'_i$) of a second dielectric material, the refraction index of the second material at an operating wavelength of the filter being smaller than the refraction index of the first material or of the first materials at said wavelength, the $j^{th}$ dielectric portion of the second dielectric material resting on the $j^{th}$ dielectric portion of the first dielectric material or of the first dielectric materials, the sum of the thickness of the $j^{th}$ dielectric portion of the second dielectric material and of the thickness of the $j^{th}$ portion of the first dielectric material or of the first dielectric materials being equal to the thickness of the $N^{th}$ dielectric portion of the first dielectric material or of the first dielectric materials; and
   a second planar interface layer ($CI_2$), metallic or comprising a stack of at least two dielectric layers with a difference between refraction indexes greater than or equal to 0.5, resting on the dielectric portions of the second dielectric material ($P'_i$) and the $N^{th}$ dielectric portion of the first dielectric material or of the first dielectric materials ($P_N$), in contact with the dielectric portions of the second dielectric material and the $N^{th}$ dielectric portion of the first dielectric material or of the first dielectric materials,
   the interference filter comprising, for each $j^{th}$ and $k^{th}$ dielectric portion of the first dielectric material or of the first dielectric materials, a transition area between the $j^{th}$ and $k^{th}$ dielectric portions of the first dielectric material or of the first dielectric materials, the thickness of the transition area varying from the thickness of the $j^{th}$ dielectric portion of the first dielectric material or of the first dielectric materials to the thickness of the $k^{th}$ dielectric portion of the first dielectric material or of the first dielectric materials, the maximum lateral dimension of the transition area, measured orthogonally to the stacking direction, being smaller than 50 nm.

2. The interference filter of claim 1, wherein N is superior or equal to 3.

3. The interference filter of claim 2, wherein N is superior or equal to 4.

4. The interference filter of any of claims 1 to 3, wherein the first dielectric material or the first dielectric materials are selected from the group comprising silicon nitride (SiN), amorphous silicon (aSi), hafnium oxide ($HfO_x$), aluminum oxide ($AlO_x$), a film made up of aluminum, oxygen, and nitrogen ($AlO_xN_y$), a film made up of silicon, oxygen, carbon, and nitrogen ($SiO_xC_yN_z$), silicon nitride ($SiN_x$), niobium oxide ($NbO_x$), tantalum oxide ($TaO_x$), titanium oxide ($TiO_x$), hydrogenated amorphous silicon (aSiH), and mixtures of at least two of these compounds.

5. The interference filter of any of claims 1 to 4, wherein the second dielectric material is selected from the group comprising silicon dioxide ($SiO_2$), magnesium fluoride ($MgF_2$), silicon oxide ($SiO_x$), silicon oxynitride ($SiO_xN_y$), hafnium oxide ($HfO_x$), aluminum oxide ($AlO_x$), a film made up of aluminum, oxygen, and nitrogen ($AlO_xN_y$), a film made up of silicon, oxygen, carbon, and nitrogen ($SiO_xC_yN_z$), silicon nitride ($SiN_x$), and mixtures of at least two of these compounds.

6. An image sensor (50; 55; 60; 65) comprising the interference filter of any of claims 1 to 5 and wherein the interference filter (20) comprises a first elementary filter ($F_1$) comprising the first portion ($P_1$) of the first dielectric material or of the first dielectric materials and the first portion ($P'_1$) and a second elementary filter ($F_2$) comprising the second portion ($P_2$) of the first dielectric material or of the first dielectric materials.

7. The image sensor of claim 6, wherein the sensor is a color image sensor, wherein the first elementary filter ($F_1$) is a bandpass filter centered on a first wavelength, and wherein the second elementary filter ($F_2$) is a bandpass filter centered on a second wavelength.

8. The image sensor of claim 7, wherein the sensor is a color image sensor, wherein the first elementary filter ($F_1$) is

a bandpass filter centered on a third wavelength for a radiation at a first incidence relative to the interference filter (20) , and wherein the second elementary filter ($F_2$) is a bandpass filter centered on the third wavelength to within 1% for the radiation at a second incidence relative to the interference filter (20).

9. A method of manufacturing the interference filter (20) of any of claims 1 to 5, comprising the successive steps of:

a) depositing on the support (10) a first dielectric layer ($C_N$) of the first dielectric material or of the first dielectric materials on the first interface layer ($CI_1$);
b) etching the first dielectric layer to remove the first dielectric layer from a first location and keep the first layer at a second location;
c) depositing a second layer ($C_2$) of the first dielectric material or of the first dielectric materials on the first interface layer at the first location and on the first dielectric layer at the second location; and
d) forming the portion ($P'_1$) of the second dielectric material on the second layer at the first location.

10. The method of claim 9, wherein step d) comprises the steps of:

depositing a third dielectric layer (30) of the second dielectric material on the second layer ($C_2$); and
etching the third dielectric layer to reach the second dielectric layer ($C_2$) at the second location.

11. The method of claim 10, wherein the etching of the third dielectric layer (30) comprises a chem.-mech. planarization step.

**Fig 1**

**Fig 2**

**Fig 3A**

**Fig 3B**

10  CI₁                                    C₂

Fig 3C

10    CI₁        P₁              C₁      C₂

                                              } P₂

Fig 3D

P₁   30    C₁      CI₁            C₂

                                              } P₂

10

Fig 3E

F₁                        F₂

P₁'   P₁   C₁              C₂

                                              } P₂

                                              CI₁

                                              10

Fig 3F

Fig 3G

Fig 4

Fig 5

Fig 6

Fig 7

Fig 8

Fig 9

Fig 10

Fig 11

Fig 12

80

0-14° ⬇   14-21° ⬇   21-26° ⬇   26-30° ⬇

D17
D16

∘∘∘

D13
D12b
D12a   D11a-D11c
D10
D9

∘∘∘

D2
D1

0-14° ⬇ 940nm   14-21° ⬇ 940nm   21-26° ⬇ 940nm   26-30° ⬇ 940nm

$F_1$    $F_2$    $F_3$    $F_4$

Fig 13

Fig 14

85

0-14° ⇩  14-21° ⇩  21-26° ⇩  26-30° ⇩

E17
aSi — E16
SiO2
E13
E12
E11a-E11d
aSi — E10
E9

E2
E1

0-14° ⇩ 940nm  14-21° ⇩ 940nm  21-26° ⇩ 940nm  26-30° ⇩ 940nm

F₁  F₂  F₃  F₄

Fig 15

Fig 16

**RÉFÉRENCES CITÉES DANS LA DESCRIPTION**

**Documents brevets cités dans la description**

- US 8933389 B2

- FR 3020878